# EUROPEAN PATENT SPECIFICATION

(11) **EP 0 436 723 B1**
(45) Date of publication and mention of the grant of the patent: **21.06.1995**
(21) Application number: 90910173.5
(22) Date of filing: 07.07.1990
(51) Int. Cl.: C01G 3/00, C04B 35/00, C04B 35/64

(54) **OXIDE SUPERCONDUCTOR AND METHOD OF PRODUCING THE SAME**
OXYDE SUPRALEITFAHIGES MITTEL UND VERFAHREN ZUR HERSTELLUNG
SUPRACONDUCTEUR A OXYDE ET PROCEDE DE PRODUCTION D'UN TEL SUPRACONDUCTEUR

(30) Priority: 07.07.1989 JP 176472/89; 18.08.1989 JP 213722/89; 18.08.1989 JP 213723/89; 18.08.1989 JP 213730/89; 06.09.1989 JP 230754/89; 06.09.1989 JP 230756/89; 30.10.1989 JP 283650/89
(43) Date of publication of application: 17.07.1991
(73) Proprietor: MITSUBISHI MATERIALS CORPORATION, Chiyoda-ku Tokyo (JP); KABUSHIKI KAISHA KOBE SEIKO SHO, Kobe-shi Hyogo-ken 651 (JP); MATSUSHITA ELECTRIC INDUSTRIAL CO., LTD., Kadoma-shi, Osaka-fu, 571 (JP); KYOCERA CORPORATION, Yamashina-ku Kyoto-shi 607 (JP); INTERNATIONAL SUPERCONDUCTIVITY TECHNOLOGY CENTER, Tokyo (JP); THE TOKYO ELECTRIC POWER CO., INC., Chiyoda-ku, Tokyo 100 (JP)
(72) Inventor: MIYATAKE, T. Superconductivity Research Laboratory, 14-3, Shinonome 1-chome Kohto-ku (JP); KOSHIZUKA, N. Superconductivity Research Lab., 14-3, Shinonome 1-chome Kohto-ku To (JP); HAYASHI, Seiji, Kobe-shi Hyogo 655 (JP); SHIBUTANI, Kazuyuki, Kobe-shi Hyogo 651-11 (JP); KAWATE, Yoshio, Kobe-shi Hyogo 655 (JP); MASUDA, Yoshio, Kobe-shi Hyogo 650 (JP); OGAWA, Rikuo, Kobe-shi Hyogo 651-11 (JP); FUKUMOTO, Yoshito, Kobe-shi Hyogo 651-16 (JP); WADA, T. Superconductivity Research Laboratory, 14-3, Shinonome 1-chome Kohto-ku Tokyo (JP); KORIYAMA, S. Superconductivity Research Laboratory, 14-3, Shinonome 1-chome Kohto-ku Tokyo (JP); SAKURAI, T. Superconductivity Research Laboratory, 14-3, Shinonome 1-chome Kohto-ku Tokyo (JP); SUZUKI, N. Superconductivity Research Laboratory, Center 14-3, Shinonome 1-chome Kohto-ku (JP); YAMAUCHI, H. Superconductivity Research Laboratory, 14-3, Shinonome 1-chome Kohto-ku Tokyo (JP); TANAKA, S. Superconductivity Research Laboratory, 14-3,Shinonome 1-chome,Kohto-ku,Tokyo (JP)
(74) Representative: Bühling, Gerhard, Dipl.-Chem.
(86) International application number: JP9000877
(87) International publication number: WO9100847

(56) References cited:
- EP-A- 0 305 179
- JP-A- 218 321
- JP-A- 649 850
- JP-A- 1 111 766
- JP-A- 1 257 159
- NATURE, vol. 341, 7th September 1989, pages 41-42; T. MIYATAKE et al.: "Tc increased to 90 K in YBa2Cu4O8 by Ca doping"
- PHYSICA C, vol. 167, 1990, pages 102-106, Elsevier Science Publishers B.V, North-Holland, NL; K. SHIBUTANI et al.: "Bulk synthesis of Ln1-xCaxBa2Cu408(Ln=Y, Ho) by the oxygen-hip technique"

## Description

The present invention concerns an oxide superconductor having a superconducting transition temperature (hereinafter sometimes referred to simply as Tc) sufficiently higher than the liquid nitrogen temperature and less suffering from a problem of releasing oxygen during fabrication to result in fluctuating of Tc, as well as a method of manufacturing such an oxide superconductor.

### Background Art

As a typical oxide superconductor having Tc higher than the liquid nitrogen temperature, a perovskite RBa₂Cu₃O₇ (in which R is one or more of elements selected from the group consisting of Y and lanthanide series rare earth elements) of a three-layered structure having Tc = 90K has been discovered (Appl. Phys. Lett. Vol. 51 (1987) p57).

It has, however, been known that the oxide super conductor described above has a nature that oxygen atoms as a constituent element is liable to be released by the effect of heat during fabrication and, accordingly, the oxygen content varies depending on the conditions for heat treatment upon fabrication, which is accompanied by orthorhombic tetragonal phase transformation and this greatly varies Tc within a range from 0K to 90K (Phys. Rev. B36 (1987) p5719).

For instance, in a case of using a method of filling a powder of RBa₂Cu₃O₇ into a silver tube, cold drawing the pipe into a wire-like shape and then applying a sintering heat treatment (800 - 900° C) to the powder portion to obtain a super conducting wire (silver sheath wire method), there has been a drawback that the oxygen atoms are released during the sintering heat treatment to deteriorate the superconducting characteristics.

On the other hand, RBa₂Cu₄O₈ type oxides have been noted as an important substance from a practical point of view since they are stable with no release of oxygen even under heating up to about 850° C and they have Tc of about 80K, which is higher than the liquid nitrogen temperature.

By the way, the following two methods have been proposed as a method of manufacturing a RBa₂Cu₄O₈ type oxide super conductor.
(1) A method of applying a heat treatment to a calcined powder in a high pressure atmosphere of pure oxygen (for instance, 930° C x 8 hrs, oxygen pressure: 10MPa (100 atm)) (High pressure oxygen method: Tc = 81K, Nature 336 (1988) p660 - 662 or Phys. Rev. B39 (1988) p 7347 - 7350)).
(2) A method of mixing a calcined powder with a catalyst such as sodium carbonate, which is then applied with a heat treatment for a long period of time in an oxygen gas stream (Atmospheric pressure method; Tc = 77K; Nature 338 (1989) 1 328 - 330).

However, as the result of confirmation by the experiment conducted by the present inventors, et al, the following drawbacks were found in the methods (1) and (2) above.

It has been found in the method (1) that RBa₂Cu₃O_{7-δ} phase, R₂Ba₄Cu₇O_{z} phase or the like is formed depending on the conditions of temperature and pressure, by which the amount of RBa₂Cu₄O₈ formed is extremely reduced to eliminate the characteristics inherent to the RBa₂Cu₄O₈ phase. In addition, since impurities are liable to be left in the product and a long time is required for the heat treatment in the method (2), it is not suitable to practical application.

In addition, although RBa₂Cu₄O₈ type oxides have Tc higher than the liquid nitrogen temperature, it is about 80K in each of them and the liquid nitrogen temperature margin is too small, it is difficult for practical application and, accordingly, it has been expected for the development of an RBa₂Cu₄O₈ type oxide having higher Tc.

The present invention has been achieved in order to overcome such technical problems and an object thereof is to provide a stable oxide superconductor having Tc sufficiently higher than the liquid nitrogen temperature and not causing release of oxygen at high temperature during fabrication, as well as a method of manufacturing such an oxide superconductor.

### Disclosure of the Invention

An oxide superconductor according to the present invention is an oxide superconductor represented by the chemical formula :(R₁₋ₓCaₓ)Ba₂Cu₄O₈, wherein R is one or more of elements selected from the group consisting of Y and lanthanide series rare earth elements, and x is within a range: 0.001 ≦ x ≦ 0.5. One of the most prominent features of the oxide superconductor according to the present invention is that a portion of R in RBa₂Cu₄O₈ is partially substituted with Ca, by which Tc is as high as about 90K and excellent stability is also provided against high temperature heat treatment.

Accordingly, in a case of fabricating the oxide superconductor described above into a silver sheath wire material, a stable superconducting wire material can be prepared without deteriorating superconducting characteristics even after the sintering heat treatment as a final step. The above-mentioned oxide superconductor can be formed by various methods such as sputtering and, in particular, a method of applying a hot isostatic pressing treatment to a starting powder mixture for manufacturing an oxide superconductor comprising R (R having the same meanings as described above), Ca, Ba, Cu and O in a mixed atmosphere of an inert gas and an oxygen gas, within a temperature range of 850 to 1100° C is effective. Further, it has been found that an oxide superconductor can be manufactured at a higher efficiency by hindering the formation of an oxide as an intermediate material represented by (R₁₋ₓCaₓ)Ba₂Cu₃O₇ (in which x represents the same range as described above and also hereinafter) during manufacturing step, that is, before hot isostatic pressing treatment.

### Brief Description of Drawings

Fig. 1 is a diagram for illustrating a chemical structure of RBa₂Cu₄O₈;
Fig. 2 is a diagram for illustrating a chemical structure of RBa₂Cu₃O₇;
Fig. 3 is a powder X-ray diffraction pattern of YBa₂Cu₄O₈;
Fig. 4 is a powder X-ray diffraction pattern of Y_{0.9}Ca_{0.1}Ba₂Cu₄O₈ obtained in Example 1;
Fig. 5 is a graphic diagram illustrating superconducting characteristics of a (Y₁₋ₓCaₓ)Ba₂Cu₄O₈ type superconducting powder according to the present invention;
Fig. 6 is a graphic diagram illustrating the result of thermogravimetric analysis for the specimen in Example 1;
Fig. 7 is a powder X-ray diffraction pattern in the resultant phase of a sintering product of Y_{0.75}Ca_{0.25}Ba₂Cu₄O₈ obtained in Example 2;
Fig. 8 is a graphic diagram illustrating superconducting characteristics of Y_{0.75}Ca_{0.25}Ba₂Cu₄O₈ obtained in Example 2;
Fig. 9 is a graphic diagram illustrating the result of thermogravimetric analysis for Y_{0.8}Ca_{0.2}Ba₂Cu₄O₈ and Y_{0.7}Ca_{0.3}Ba₂Cu₄O₈ obtained in Example 2;
Fig. 10 is a powder X-ray diffraction pattern in the resultant phase of the sintering product of Ho_{0.9}Ca_{0.1}Ba₂Cu₄O₈ according to the present invention;
Fig. 11 is a graphic diagram illustrating superconducting characteristics (relationship between temperature and resistivity) of (Ho₁₋ₓCaₓ)Ba₂Cu₄O₈ according to the present invention;
Fig. 12 is a graphic diagram illustrating the result of thermogravimetric analysis for the specimen in Example 4;
Fig. 13 is a powder X-ray diffraction pattern for Y_{0.9}Ca_{0.1}Ba₂Cu₄O₈ obtained in Example 6;
Fig. 14 is a powder X-ray diffraction pattern for Ho_{0.95}Ca_{0.05}Ba₂Cu₄O₈ obtained in Example 6;
Fig. 15 is a graphic diagram illustrating superconducting characteristics of Y_{0.9}Ca_{0.1}Ba₂Cu₄O₈;
Fig. 16 is a graphic diagram illustrating superconducting characteristics of Ho_{0.95}Ca_{0.05}Ba₂Cu₄O₈;
Fig. 17 is a powder X-ray diffraction pattern for Y_{0.9}Ca_{0.1}Ba₂Cu₄O₈ obtained in Example 8;
Fig. 18 is a powder X-ray diffraction pattern for Ho_{0.95}Ca_{0.05}Ba₂Cu₄O₈ obtained in Example 8;
Fig. 19 is a graphic diagram illustrating superconducting characteristics of the oxide superconductor powder obtained in Example 8; and
Fig. 20 is a graphic diagram illustrating the result of thermogravimetric analysis for the oxide superconductor powder obtained in Example 9.

### Best Mode for Carrying Out the Invention

The present inventors have made a study from various aspects in order to realize a stable superconductor having Tc sufficiently higher than the liquid nitrogen temperature and not causing the release of oxygen even at a high temperature.

The present inventors have at first made various studies on the optimum form in view of the structure of a RBa₂Cu₄O₈ type oxide. As a result, it has been found in a RBa₂Cu₄O₈ type oxide in which single CuO chains are changed into double CuO chains in a three-layered perovskite RBa₂Cu₃O₇ type crystal structure that (R₁₋ₓCaₓ)Ba₂Cu₄O₈ type oxide in which from 0.1 to 50 atm% of R is substituted with Ca has Tc sufficiently higher than the liquid nitrogen temperature by the effect of Ca substitution and can be fabricated stably with no release of oxygen even under a heating condition near 850° C.

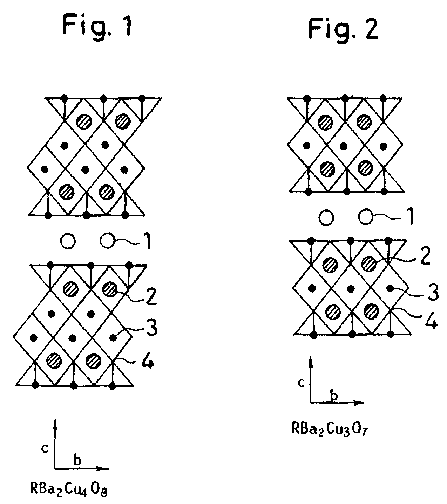

Fig. 1 shows a structure of RBa₂Cu₄O₈ as a fundamental structure of the oxide superconductor according to the present invention and Fig. 2 shows a structure of a conventional RBa₂Cu₃O₇. In Figs. 1 and 2, 1 represents R, 2 represents Ba, 3 represents Cu and 4 represents O arranged at the intersections of linear segments respectively.

The oxide superconductor (R₁₋ₓCaₓ)Ba₂Cu₄O₈ according to the present invention is a RBa₂Cu₄O₈ oxide having double CuO chains instead of single CuO chains in the perovskite RBa₂Cu₃O₇ type of a three layered crystal structure shown in Fig. 1, wherein from 0.1 to 50 atm% of R is substituted with Ca. Remarkable elevation of Tc by the Ca substitution is the most prominent feature of the present invention.

Since the powder of such (R₁₋ₓCaₓ)Ba₂Cu₄O₈ type oxide does not release oxygen even under a high temperature condition upon wire fabrication, an aimed superconductor wire material can be obtained by packing the powder into a sheath material, drawing the material and then applying sintering.

In the present invention, the amount of the Ca substitution for the (R₁₋ₓCaₓ)Ba₂Cu₄O₈ type oxide (that is the range for x) is defined as from 0.001 to 0.5 with the reasons described below. That is, the effect of the substitution appears with x of greater than 0.001, whereas x does not substantially exceed 0.5 under the conditions for the manufacturing method according to the present invention. A preferred range is from 0.001 to 0.2.

Further, the composition for the starting material powder in the present invention is not always defined as: R or (R + Ca):Ba:Cu = 1:2:4 but a composition which deviates therefrom may be used so long as a (R₁₋ₓCaₓ)Ba₂Cu₄O₈ phase is substantially formed finally. However, it is preferred to define the composition of the starting material powder as: R or (R + Ca):Ba:Cu = 1:2:4 in order to form the phase stably. For the form of the starting material powder, oxides such as Y₂O₃, R₂O₃, CaO, BaO and Cu₂O may be used preferably with a view to easily proceeding the forming reaction. In addition, the (R₁₋ₓCaₓ)Ba₂Cu₄O₈ according to the Present invention can be manufactured by various kinds of methods such as sputtering and coprecipitation.

The (R₁₋ₓCaₓ)Ba₂O₄O₈ according to the present invention can be manufactured by using various kinds of methods such as sputtering or coprecipitation as has been described above, but it has been found that the method of using HIP as a means for manufacturing the (R₁₋ₓCaₓ)BaₓCu₄O₈ is effective. That is it has been found that an aimed (R₁₋ₓCaₓ)Ba₂Cu₄O₈ type oxide superconductor can be obtained at a high efficiency by applying a HIP treatment within a temperature range of 850 to 1100° C in a mixed atmosphere of an inert gas and an oxygen gas. This is referred to as an O₂-HIP method.

The HIP treatment in O₂-HIP method in the present invention is a treatment in a mixed atmosphere of an inert gas and an oxygen gas. Accordingly, if the same pressure as that with pure oxygen (for example 20MPa (200 atm)) is to be attained by an oxygen partial pressure, the total pressure as the mixed atmosphere can be increased remarkably. For instance, it is considered that if the molar ratio of the inert gas and oxygen is defined as 1:1, the total pressure can be made to 40MPa (400 atm), while the total pressure may be increased to 100MPa (1000 atm) if the ratio is defined as 4:1 by which the diffusion of Cu atoms is further improved to promote the formation of (R₁₋ₓCaₓ)Ba₂Cu₄O₈ type oxide super conductor. Further, this can provide a great merit also in view of the operation safety, as compared with the case of increasing the total pressure by pure oxygen.

It is necessary that the temperature for the HIP treatment in the manufacture of the (R₁₋ₓCaₓ)Ba₂Cu₄O₈ type oxide superconductor is at least higher than 850° C with a view point of suppressing the formation of the RBa₂Cu₃O₇ type oxide and promoting the formation of the (R₁₋ₓCaₓ)Ba₂Cu₄O₈ type oxide. However, it is also necessary to restrict the upper limit for the temperature to 1100° C since R₂Ba₄Cu₇O_{z} is liable to be formed to result in a mixed phase if it exceeds 1100° C.

Further, referring to the relationship between the HIP treatment step in the O₂-HIP method in the present invention and the product molding step, (1) starting material powders may be mixed previously, then fabricated into a thin film or wire and, subsequently, applied with a HIP treatment into a superconductor, or (2) a HIP treatment may be applied in a powdery state of the starting material into a superconductor and then fabricating the material into a thin film or wire.

By the way, according to the experimental confirmation of the present inventors, it has been found that if the starting material powder is calcined by the O₂-HIP method in the present invention, some disadvantages may be caused in the subsequent HIP treatment. That is, if the starting material powder is calcined, (R₁₋ₓCaₓ)Ba₂Cu₃O₇ (hereinafter sometimes referred as 1-2-3 phase) is formed, and the (R₁₋ₓCaₓ)Ba₂Cu₄O₈ phase (hereinafter sometimes referred as 1-2-4 phase) by way of the 1-2-3 phase, the time required for the HIP treatment is increased. However, since the 1-2-4 phase is more decomposable as compared with the 1-2-3 phase, if the HIP treatment at a high temperature is continued for a long period of time, there is a disadvantage that the 1-2-4 phase once formed is again decomposed into the 1-2-3 phase.

In view of the above, the present inventors have made a study with a view point of manufacturing the (R₁₋ₓCaₓ)Ba₂O₄O₈ type oxide superconductor in a short period of time and at a high yield. As a result, it has been found that the intended purpose can be attained more effectively, by avoiding a heat treatment step easily forming the 1-2-3 phase as much as possible, applying the HIP treatment to the starting material powder in a state where the 1-2-3 phase is not formed thereby directly forming the 1-2-4 phase, and terminating the reaction in a state of suppressing the once formed 1-2-4 phase from being decomposed into the 1-2-3 phase.

By using such a means, since the synthesis for the 1-2-3 phase does not proceed before the HIP treatment and the decomposition of the once formed 1-2-4 phase into the 1-2-3 phase can be suppressed as much as possible, reaction easily causing the 1-2-3 phase such as calcination, preliminary heat treatment can be saved to shorten the processing time, and the HIP treatment for a long period of time is no more required to make the manufacturing steps efficient as a whole. Further, there is no requirement for using a carbonate as the starting material or a catalyst, so that a disadvantage of degradation for the superconducting characteristics caused by the incorporation of carbon atoms as the impurity is not caused. However, it is not always necessary in the present invention to save the calcination or preliminary heat treatment, but HIP pretreatment to some extent before the HIP treatment may be allowable.

The oxide superconductor provided by the present invention has a characteristic constitution of having a chemical structure of the 1-2-4 phase as apparent from the description throughout the specification but it will be understood easily by those skilled in the art that this does not mean to positively exclude the incorporation of the 1-2-3 phase to some extent providing that this does not hinder the advantageous effect of the present invention.

The present invention will now be explained more specifically for the constitution and the function and the effect thereof referring to examples and comparative examples, but the present invention is not of course restrict to the following examples.

### Example 1

Powders of Y₂O₃, Ba(NO₃)₂, CuO, CaCO₃ at 99.9% purity were mixed such that x = 0, 0.025, 0.05, 0.10, 0.20, 0.25 in the chemical formula (Y₁₋ₓCaₓ)Ba₂Cu₄O₈ and applied with a calcining treatment in air at 850° C x 24 hrs. After pulverizing the calcined powder, it was mixed with an identical volume of Na₂CO₃. After applying a heat treatment at 800° C for 72 hrs in air further to the powder mixture, Na₂CO₃ was separated by water washing to obtain a superconducting powder of (Y₁₋ₓCaₓ)Ba₂Cu₄O₈.

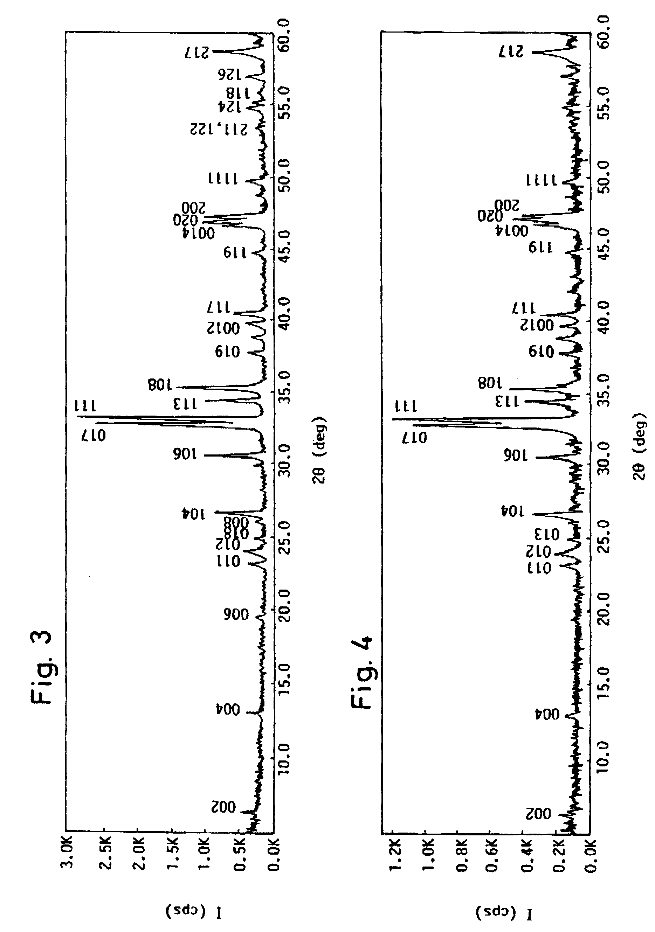

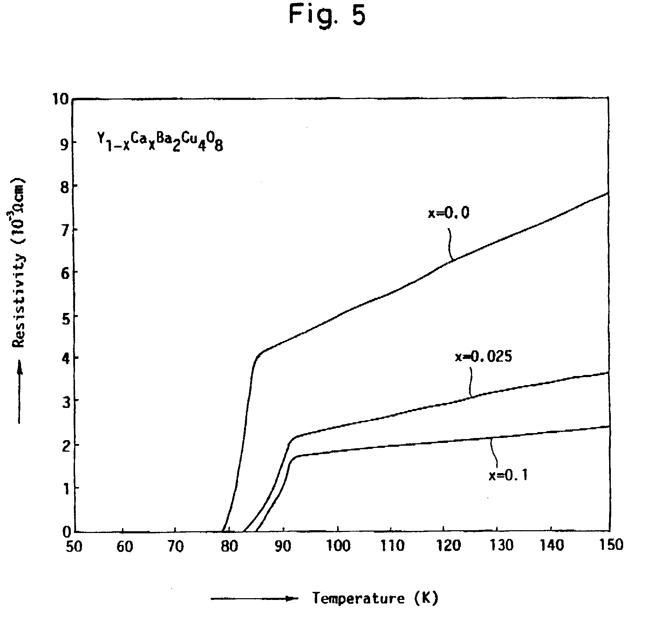

It was confirmed by powder X-ray diffractiometry that the superconductor powder of the (Y₁₋ₓCaₓ)Ba₂Cu₄O₈ was a YBa₂Cu₄O₈ type structure. The results of the powder X-ray diffractiometry are shown in Figs. 3 and 4 for the confirmation. Fig. 3 is a powder X-ray diffraction pattern for YBa₂Cu₄O₈ and Fig. 4 is a powder X-ray diffraction pattern for Y_{0.9}Ca_{0.1}Ba₂Cu₄O₈. In Figs. 3 and 4, numerals in the figures represent indices for the peaks in the X-ray diffractiometry. Since the powder X-ray diffractiometry patterns are substantially identical between Figs. 3 and 4, it can be seen that the crystal structure of Y_{0.9}Ca_{0.1}Ba₂Cu₄O₈ is in the YBa₂Cu₄O₈ type structure. That is, the superconducting powder of (Y₁₋ₓCaₓ)Ba₂Cu₄O₈ is in the YBa₂Cu₄O₈ type structure. Superconducting characteristics of the superconducting powder of (Y₁₋ₓCaₓ)Ba₂Cu₄O₈ manufactured as described above were examined by resistance measurement. Specimens for the resistance measurement were prepared by molding the superconducting powders of (Y₁₋ₓCaₓ)Ba₂Cu₄O₈ described above in a rectangular powder molding die and then applying a sintering treatment in air at 800° C for 24 hrs. The results for the measurement of the superconducting characteristics are shown in Fig. 5 (temperature vs resistivity characteristics diagram) and in Table 1. In Table 1, Tc^{on} is a temperature at which superconducting transition begins from the ordinary conducting state, and Tc^{R=0} is a temperature at which the resistance is reduced to 0.

**Table 1**

| x | X-ray diffraction | Tc^{on} | Tc^{R=0} | Remark |
|---|---|---|---|---|
| | | K | K | |
| 0 | Superconducting single phase | 76 | 74 | Comparative Example |
| 0.025 | Superconducting single phase | 90 | 82 | Example |
| 0.05 | Superconducting single phase | 90 | 82 | Example |
| 0.10 | Super-conducting single phase | 91 | 84 | Example |
| 0.20 | Super-conducting single phase | 92 | 87 | Example |
| 0.25 | Super-conducting phase + impurity phase | 90 | 86 | Example |

As apparent from Table 1, each of the specimens for the superconducting powder of (Y₁₋ₓCaₓ)Ba₂Cu₄O₈ according to the present invention has Tc of about 90K, and 90K is a sufficiently higher temperature than 77K of the liquid nitrogen temperature.

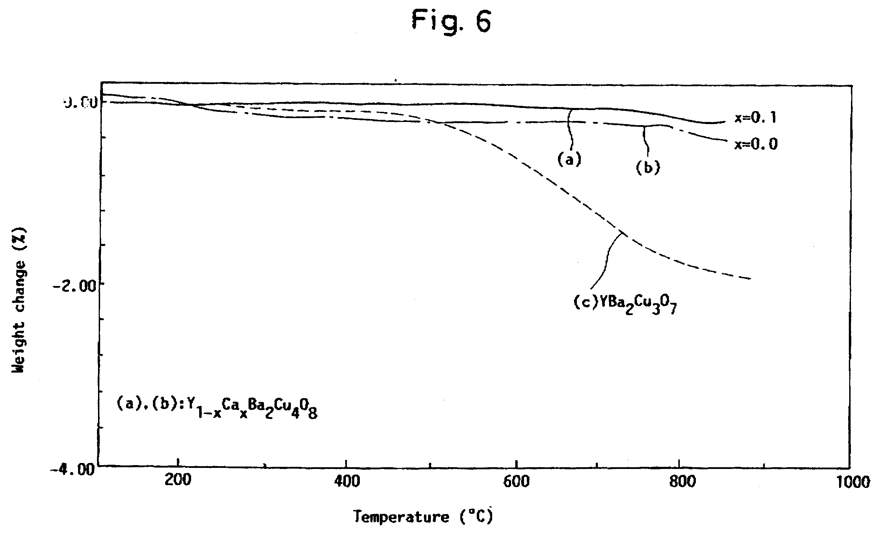

Fig. 6 is a graph illustrating the result of the thermogravimetric analysis for (Y₁₋ₓCaₓ)Ba₂Cu₄O₈ obtained in Example 1. It can be seen that the weight does not change and is stable up to 850° C.

### Example 2

Powders of Y₂O₃, Ba(NO₃)₂, CuO and CaCO₃ at 99.9% purity were mixed such that x = 0.2, 0.25, 0.3, 0.4, 0.5 and 0.6 in the chemical formula: (Y₁₋ₓCaₓ)Ba₂Cu₄O₈ and then calcined in oxygen at 850° C x 24 hrs. After or calcination, specimens were pulverized and then molded each into a rectangular form. The molding product was preliminarily sintered in oxygen at 800° C for 5 hrs. The preliminary sintering product was further applied with a heat treatment in an atmosphere of 100MPa (1000 atm.) Ar + 20%O₂. Then, the product was heated at 200° C/hr, maintained at 960° C for 6 hrs, further heated upto 1050° C at a rate of 200° C/hr and then maintained at that temperature for 6 hours. Cooling was conducted down to 300° C at a rate of 200° C/hr, and the specimen was taken out into air after reducing the pressure to 0.1MPa (1 atm.).The specimen was pulverized again and molded. The molding product was sintered in oxygen at 800° C or 20 hours to obtain a predetermined specimen.

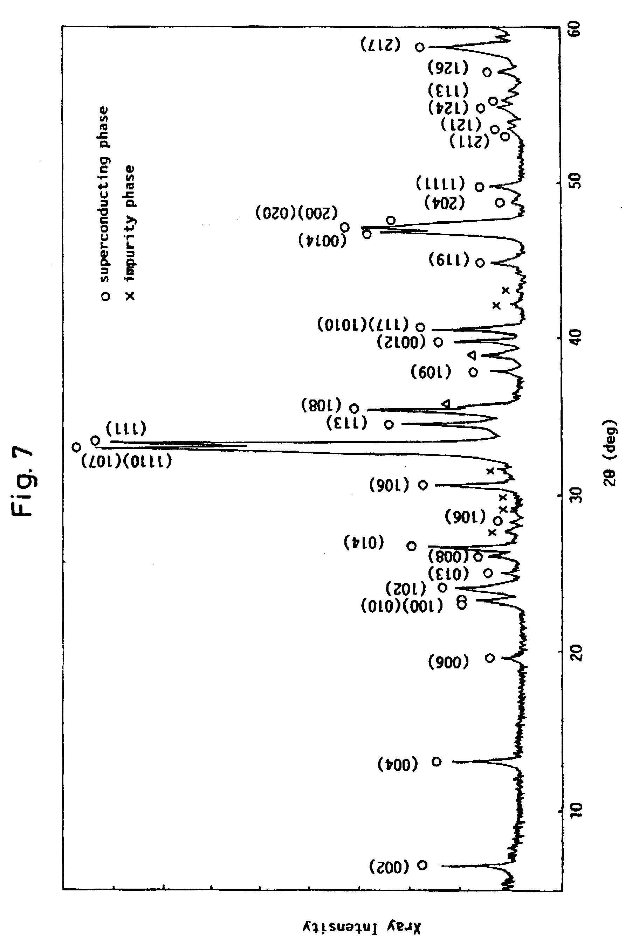

The resultant phase of the thus obtained sintering product of (Y₁₋ₓCaₓ)Ba₂Cu₄O₈ was confirmed by using powdery X-ray diffractiometry. It has been confirmed that any of the main ingredients in the resultant specimen had a YBa₂Cu₄O₈ crystal structure. Fig. 7 shows the graphic indication of powdery X-ray diffractiometry for the specimen with x = 0.25, in which numerals in the figure is indices for the peaks based on YBa₂Cu₄O₈ type structure. The second phase is slightly observed in this specimen. The resultant phases of the specimens were collectively shown in Table 2. It has a (Y₁₋ₓCaₓ)Ba₂Cu₄O₈ single phase within a range of x from 0 to 0.2 and contains the second phase when x reaches 0.25.

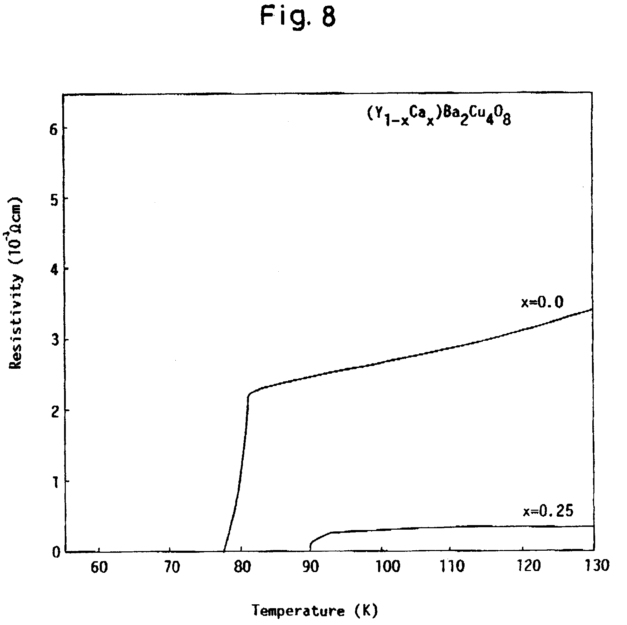

Superconducting characteristics of the specimens were examined by resistance measurement. The results are shown in Fig. 8 and Table 2. In Table 2, ρ^{300K} is resistivity at 300K.

**Table 2**

| X | X-ray diffraction | Tc^{on} | Tc^{R=0} | ρ^{300K} | Porosity | Remarks |
|---|---|---|---|---|---|---|
| | | K | K | x10⁻³Ωcm | % | |
| 0 | Superconducting single phase | 82 | 78 | 6.3 | 33 | Comp. Example |
| 0.2 | Superconducting single phase | 92 | 88 | 0.85 | 7 | Example |
| 0.25 | Superconducting phase+impurity phase | 93 | 88 | 0.62 | 5 | Example |
| 0.3 | Superconducting phase+impurity phase | 94 | 87 | 0.43 | 4 | Example |
| 0.4 | Superconducting phase+impurity phase | 94 | 86 | 0.63 | 7 | Example |
| 0.5 | Superconducting phase+impurity phase | 94 | 82 | 0.92 | 9 | Example |
| 0.6 | Superconducting phase+impurity phase | 93 | 72 | 8.5 | 8 | Comp. Example |

As can be seen from Fig. 8 and Table 2, each of the superconducting specimens of (Y₁₋ₓCaₓ)Ba₂Cu₄O₈ in this example shows a superconducting transition temperature in the order of 90K. The superconducting transition temperature is a temperature sufficiently higher than the boiling point of liquid nitrogen (77K). When the resistance values of the specimens at a room temperature are compared to each other, the resistance value at room temperature is lowered along with the increase for the content x of Ca. In this way, a high critical current density can be expected for a specimen with low resistance value at a room temperature. The resistance at the room temperature is the lowest for the specimen with x being 0.3 and the resistance value is increased along with increase of x above 0.4 and the resistance value is higher at x = 0.6 than at x = 0.

Further, the porosity for each of the specimens was determined by optical microscopic observation for ground specimens. The values are collectively shown in Table 2. In view of the results, the porosity is lowered along with the increase of x and it is about 4% in the specimen at x = 0.3. However, the porosity does not change even when x is increased further.

As a result of X-ray diffractiometry and, while taking the result of measurement for the resistivity and the porosity at a room temperature into consideration, it is supposed that lowering of the resistivity of the specimen at a room temperature along with the increase of x is due to the effect of solid-solubilization of Ca into the Y site of YBa₂Cu₄O₈, as well as due to the fact that the resultant second phase acts as a sintering aid if x exceeds 0.2 to make the density of the specimen higher. However, if the second phase is too much, it reduces the volumic ratio of the superconductor and this is not desirable. The upper limit for x is 0.5.

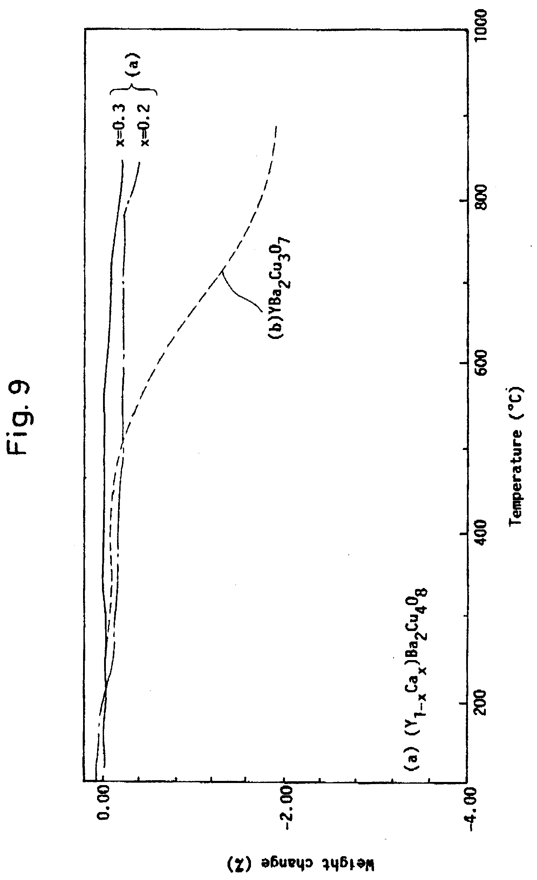

Further, as shown, for example, in Fig. 9(a), as a result of the thermogravimetric analysis for the specimen at x = 0.3, since the weight does not change from an ambient temperature upto about 850° C and shows reduction of weight between 850 to 900° C, it can be confirmed that it is present stable with neither intrusion nor release of oxygen upto high temperature of 850° C. However, in the conventional superconductor YBa₂Cu₃O₇, oxygen is released remarkably at 400 - 800° C as shown in Fig. 9(b).

As can be seen from the foregoing explanations according to this example, the superconductor YBa₂Cu₄O₈ as the matrix has a superconducting transition temperature at 80K and is less sinterable and the sintering product has a porosity of greater than 30%, wherein it has a composition of (Y₁₋ₓCaₓ)Ba₂Cu₄O₈ and each of the specimens in the example has a superconducting transition temperature at 90K and the sintering product has a porosity of less than 10%. Furthermore, it could be confirmed that these specimens had low electric resistivity at a room temperature, and they were present stably with neither intrusion nor release of oxygen up to about 850° C according to thermal analysis.

### Example 3

Powders of Ho₂O₃, Ba(NO₃)₂, CuO, CaCO₃ at 99.9% purity were mixed such that x = 0, 0.01, 0.1, 0.2, 0.3, 0.4, 0.5 and 0.6 in the chemical formula (Ho₁₋ₓCaₓ)Ba₂Cu₄O₈, and applied with calcination in air at 850° C for 24 hours. After calcination, the specimens were pulverized and molded each into a rectangular form. The molding products were preliminarily sintered in oxygen at 800° C for 5 hrs. The preliminary sintering products were applied with a heat treatment in a gas atmosphere of Ar 80% - O₂ 20% in 100MPa (1000 atm.). They were heated at 200° C/h, maintained at 960° C for 6 hrs and then further heated therefrom up to 1050° C at 200° C/h and then maintained at that temperature for 6 hrs. They were cooled down to 300° C at a rate of 200° C/h and, after reducing the pressure to 0.1MPa (1 atm), specimens were taken out in air. The specimens were further pulverized and molded. The molding products were sintered in oxygen at 800° C for 20 hrs to obtain predetermined specimens.

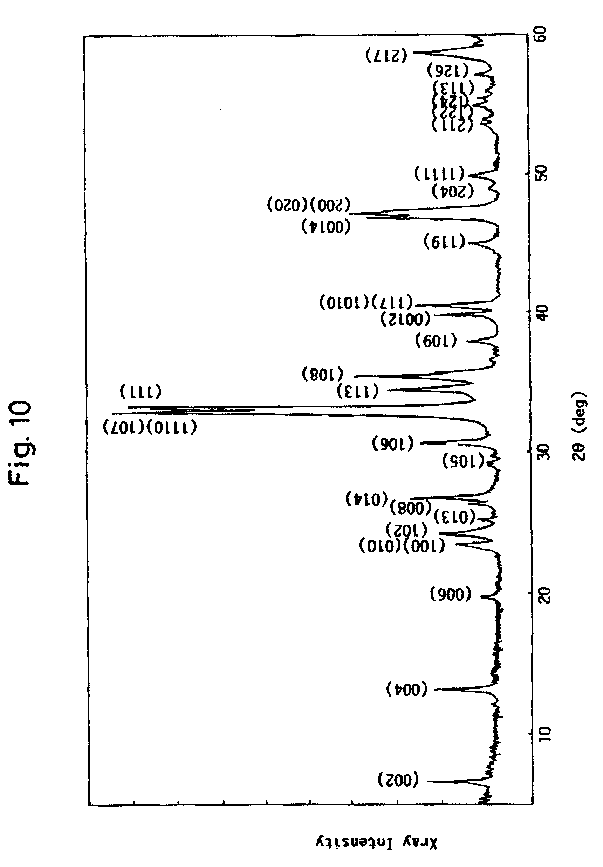

The resultant phases of the thus obtained sintering products of (Ho₁₋ₓCaₓ)Ba₂Cu₄O₈ were confirmed by using powder X-ray diffractiometry. It was confirmed that any of the main ingredients of the resultant specimens had a RBa₂Cu₄O₈ type crystal structure. Fig. 10 shows the graphic indication of powder X-ray diffractiometry for the specimen at x = 0.10. Numerals in the figure are indices for the peaks based on the RBa₂Cu₄O₈ type structure. Each of the specimens was in a single superconducting phase. The resultant phases of the specimens are collectively shown in Table 3. They consist of a single (Ho₁₋ₓCaₓ)Ba₂Cu₄O₈ phase and come to contain the second phase when x is increased to 0.30.

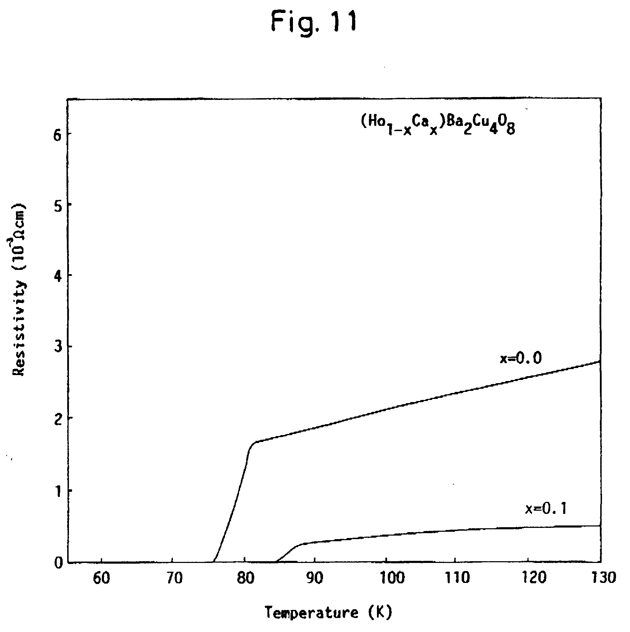

Superconducting characteristics of the specimens were examined by resistance measurement. The results are shown in Fig. 11 and Table 3.

**Table 3**

| X | X-ray diffraction | Tc^{on} | Tc^{R=0} | ρ^{300K} | Porosity | Remarks |
|---|---|---|---|---|---|---|
| | | K | K | x10⁻³Ωcm | % | |
| 0 | Superconducting single phase | 81 | 76 | 5.8 | 35 | Comp. Example |
| 0.01 | Superconducting single phase | 83 | 80 | 1.23 | 15 | Example |
| 0.1 | Superconducting single phase | 88 | 84 | 0.82 | 12 | Example |
| 0.2 | Superconducting single phase | 93 | 89 | 0.60 | 9 | Example |
| 0.3 | Superconducting phase+impurity phase | 94 | 88 | 0.53 | 4 | Example |
| 0.4 | Superconducting phase+impurity phase | 94 | 86 | 0.82 | 7 | Example |
| 0.5 | Superconducting phase+impurity phase | 94 | 83 | 1.2 | 5 | Example |
| 0.6 | Superconducting phase+impurity phase | 94 | 72 | 7.2 | 6 | Example |

As can be seen from Fig. 11 and Table 3, each of the superconductor specimens (Ho₁₋ₓCaₓ)Ba₂Cu₄O₈ in this example shows a superconducting transition temperature at an order of 90K. The superconducting transition temperature is sufficiently higher than the boiling point of the liquid nitrogen, (77K). When resistance values of the specimens at a room temperature are compared, the resistance value at the room temperature is lowered along with the increase of the Ca content x. A high critical current density can be expected for such specimens with low resistance value at the room temperature. The resistance at the room temperature is the lowest at x = 0.3, and the resistance value is increased along with the increase of x above 0.4, in which the value is greater at x = 0.6 than at x = 0.

Further, the porosity of the specimens was determined by optical microscopic observation. The values are collectively shown in Table 3. From the results, the porosity is lowered along with the increase of x and is about 5% in the specimen at x = 0.3. However, the porosity scarcely changes even if x increases further.

As a result of X-ray diffractiometry and, while taking the results of the measurement for the resistivity and the porosity at the room temperature into consideration, it is considered that the lowering in the resistivity of the specimen at the room temperature along with the increase of x is due to the effect of solid-solubilization of Ca into the Ho site in HoBa₂Cu₄O₈, as well as due to the fact that the resultant second phase acts as a sintering aid if x exceeds 0.2 to make the density of the specimen higher. However, since the volumic fraction of the superconductor is reduced if the second phase is too much, it is not desired. Accordingly, a preferred range for x : 0.001 ≦ x ≦ 0.2,

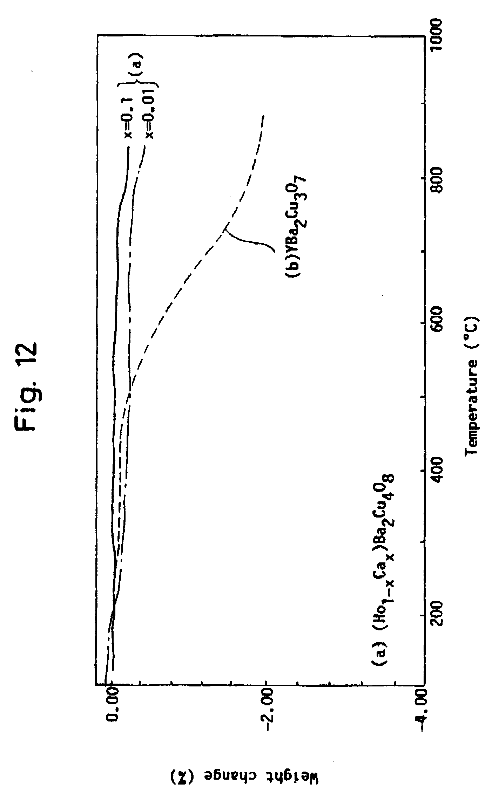

Further, as shown, for example, in Fig. 12(a), as a result of the thermogravimetric analysis for the specimen at x = 0.1, weight does not change from the ambient temperature up to about 850° C and the weight shows reduction between 850 - 900° C, it could be confirmed that it is present stably with no intrusion for release of oxygen upto high temperature of 850° C.

However, in the conventional superconductor HoBa₂Cu₃O₇ oxygen is remarkably released at 400 - 800° C as shown in Fig. 12(b).

As can be seen from the foregoing explanations according to this example, the superconductor HoBa₂Cu₄O₈ as the matrix has a Tc of 80K and is less sinterable and, accordingly, the porosity of the sintering product is more than 30%, whereas a specimen having the composition of (Ho₁₋ₓCaₓ)Ba₂Cu₄O₈ and x within a range of 0.001 ≦ X ≦ 0.5 has a superconducting transition temperature at about 90K and the porosity of the sintering product is less than 20%. Furthermore, it could be confirmed that the specimens have low electric resistivity at a room temperature and is present stably with neither intrusion nor release of oxygen upto about 850° C by thermal analysis.

### Example 4

Specimens were prepared in the same procedures as those in Example 1 by replacing Ho in (Ho₁₋ₓCaₓ)Ba₂Cu₄O₈ with Y, Nd, Sm, Eu, Gd, Dy, Er, Tm, Yb and Lu, and fixing at x = 0.1. Further, estimation was conducted in the same manner as in Example 3 and the results are shown in Table 4.

**Table 4**

| R | X-ray diffraction | Tc^{on} | Tc^{R=0} | ρ^{300K} | Porosity | Remarks |
|---|---|---|---|---|---|---|
| | | K | K | x10⁻³Ωcm | % | |
| Y | Superconducting single phase | 88 | 84 | 0.82 | 12 | Example |
| Nd | Superconducting single phase | 89 | 83 | 0.90 | 14 | Example |
| Sm | Superconducting single phase | 89 | 84 | 0.88 | 13 | Example |
| Eu | Superconducting single phase | 90 | 84 | 0.86 | 13 | Example |
| Gd | Superconducting single phase | 93 | 87 | 0.74 | 12 | Example |
| Dy | Superconducting single phase | 93 | 87 | 0.70 | 11 | Example |
| Er | Superconducting single phase | 93 | 88 | 0.72 | 10 | Example |
| Tm | Superconducting single phase | 92 | 86 | 0.88 | 10 | Exaple |
| Yb | Superconducting phase+impurity phase | 92 | 86 | 0.92 | 8 | Example |
| Lu | Superconducting phase+impurity phase | 88 | 81 | 1.01 | 8 | Example |

As in Table 4, it can be seen that similar effects can also be obtained when R is replaced from Ho to any one of Y, Nd, Sm, Eu, Gd, Dy, Er, Tm, Yb and Lu.

Accordingly, since the oxide superconductor according to the present invention is stable without deteriorating superconducting characteristics in the sintering heat treatment step as the final step in the case of fabricating into a sheath wire, as well as it is easily sinterable, a superconducting wire of high critical current density in which each of particles is sintered at high density can be manufactured.

Further, the oxide superconductor according to the present invention can be molded at a high density in a case of applying high temperature molding by using a binder. That is, the conventional superconductor RBa₂Cu₃O₇ can not be removed with the binder at a temperature higher than 400° C, the binder can be removed at lower than 800° C in the case of the superconductor according to the present invention. Since this enables high density molding, the superconducting current density can be improved further.

### Example 5

Powders of Y₂O₃, Ho₂O₃, BaCO₃, CuO and CaCO₃ at 99.9% purity were used and a mixture of starting powders was prepared such that x was 0, 0.05, 0.1, 0.2, 0.3 and 0.5 in (R₁₋ₓCaₓ)Ba₂Cu₄O₈ (in which R = Y, Ho), and applied with calcination in air at 880° C x 16 hrs. After pulverizing the calcined powder, HIP treatment was applied for 10 hrs in a mixed gas atmosphere of Ar-80%, 0-20% under a total pressure of 100MPa (1000 atm) (partial oxygen pressure P_{O2} = 20MPa (200 atm)) at each of temperatures of 880° C, 930° C and 980° C.

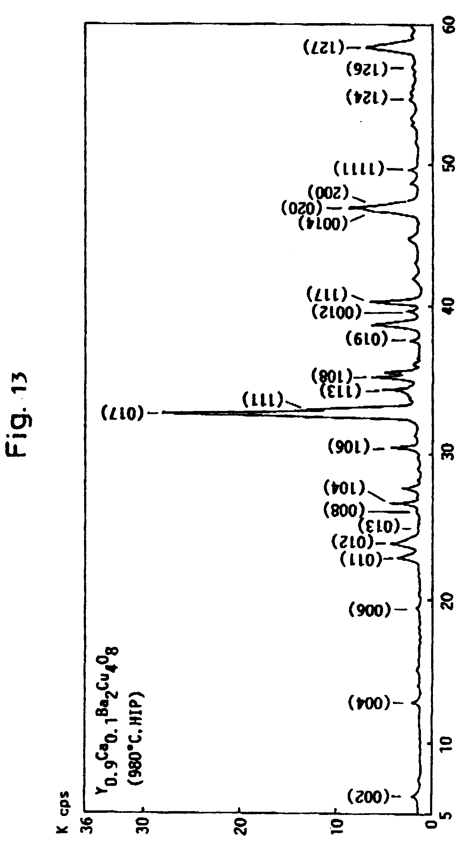

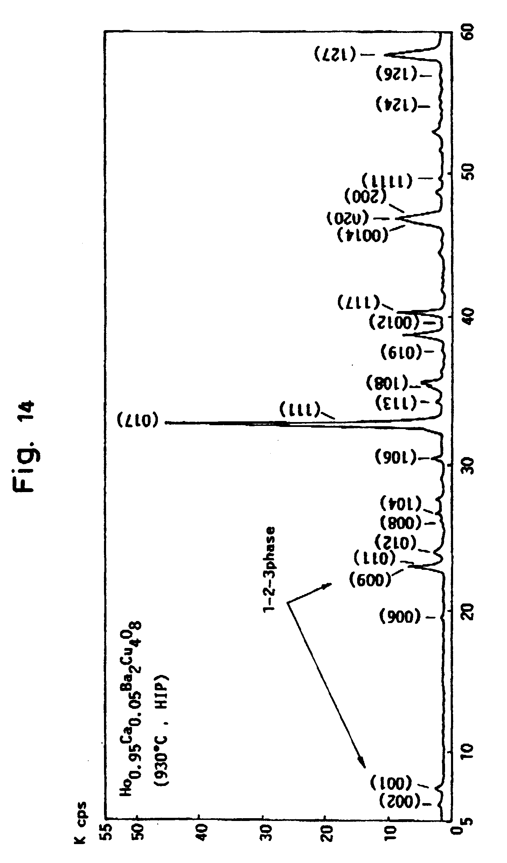

The resultant products were subjected to powder X-ray diffractiometry. A portion of the results is shown in Figs. 13 and 14. Fig. 13 corresponds to Y_{0.9}Ca_{0.1}Ba₂Cu₄O₈ (980° C, HIP) and Fig. 14 corresponds to Ho_{0.95}Ca_{0.05}Ba₂Cu₄O₇ (930° C, HIP). The powder X-ray pattern in Fig. 13 shows that the resultant powder phase shows the YBa₂Cu₄O₈ type structure, while the powder X-ray pattern in Fig. 14 shows that the resultant powder phase shows the YBa₂Cu₄O₈ type structure and that it slightly contains a YBa₂Cu₃O₇ type structure.

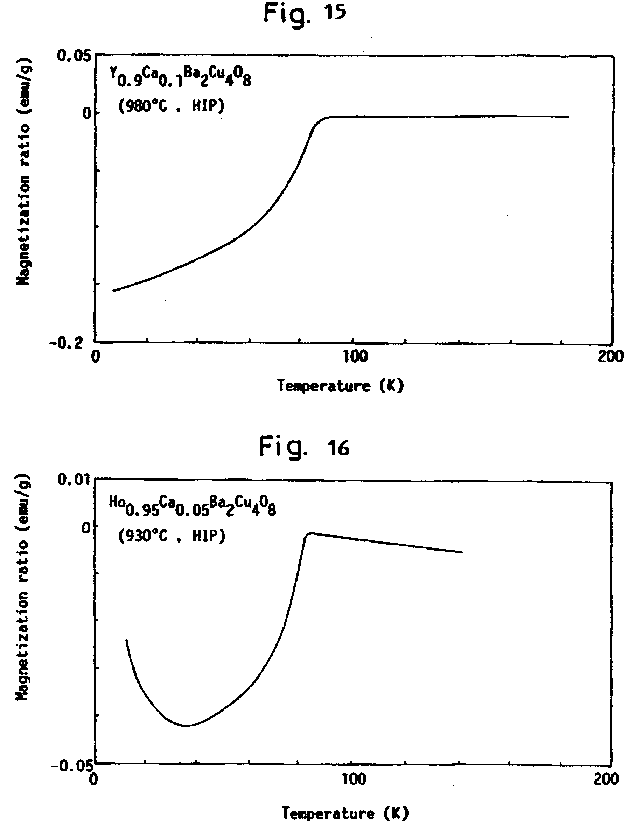

Further, superconducting characteristics of the powder specimens were measured by using a vibrating sample magnetometer. A part of the results is shown in Figs. 15 and 16. Fig. 15 corresponds to Y_{0.9}Ca_{0.1}Ba₂Cu₄O₈ (980° C, HIP), while Fig. 16 corresponds to Ho_{0.95}Ca_{0.05}Ba₂Cu₄O₈ (930° C, HIP). As apparent from the results, the (R₁₋ₓCaₓ)Ba₂ Cu₄O₈ type oxide obtained according to the present invention shows high value also for Tc.

### Example 6

Powders of Y₂O₃, Ho₂O₃, BaCO₃, CuO and CaCO₃ at 99.9% purity were used and a mixture of starting powders was prepared such that x was 0, 0.05, 0.1, 0.2, 0.3 and 0.5 in (R₁₋ₓCaₓ)Ba₂Cu₄O₈ (in which R = Y, Ho), and applied with calcined in air at 880 ° C x 16 hrs. After pulverizing the calcined powder, HIP treatment was applied for 3 hrs in mixed gas atmosphere of Ar-80%, O-20% under a total pressure of 150MPa (1500 atm) (partial oxygen pressure P_{O2} = 20MPa (200 atm)), at a temperatures of 1050° C.

The resultant powders were subjected to X-ray diffractiometry to determine the phases contained, and the Meissner volume fraction at 4.2K and the Tc value were measured for the sample only consisting of the 1-2-4 phase.

The results are shown together with the resultant phase in Table 6.

**Table 6**

| x | (Y₁₋ₓCaₓ)Ba₂CU₄O₈ | (Ho₁₋ₓCaₓ)Ba₂Cu₄O₈ |
|---|---|---|
| 0 | 37% Tc = 79K | 11% Tc = 76K |
| 0.05 | 28% Tc = 84K | 18% Tc = 82K |
| 0.1 | 19% Tc = 89K | 15% Tc = 88K |
| 0.2 | Mixed phase of 1-2-3 phase and 1-2-4 phase | Mixed phase of 1-2-3 phase and 1-2-4 phase |

From Table 6, the following conclusion can be derived. Although there is a trend that (1-2-4) phase is less formed as the Ca atom ratio is increased and Tc is elevated as the atom ration is increased, although somewhat different depending on the kind of R. It is recognized in Table 6 that the 1-2-3 phase formed by calcination does not completely change into the 1-2-4 phase and this is considered to be attributable to the short HIP processing time.

### Example 7

Powders of Y₂O₃, Ho₂O₃, BaO, CuO and CaO at 99.9% purity were used and a mixture of starting powders was prepared such that x was 0, 0.05, 0.1, 0.2, 0.3 and 0.5 in (R₁₋ₓCaₓ)Ba₂Cu₄O₈ (in which R = Y, Ho). Since BaO and CuO are unstable in air, mixing preparation was conducted in a glove box under an Ar atmosphere. Then HIP treatment was applied for 3 hrs in a mixed gas atmosphere of Ar-80%, O-20% under a total pressure of 150MPa (1500 atm) (partial oxygen pressure P_{O2} = 30MPa (300 atm)) at a temperatures of 1050° C, not by way of calcination (or preliminary heat treatment step).

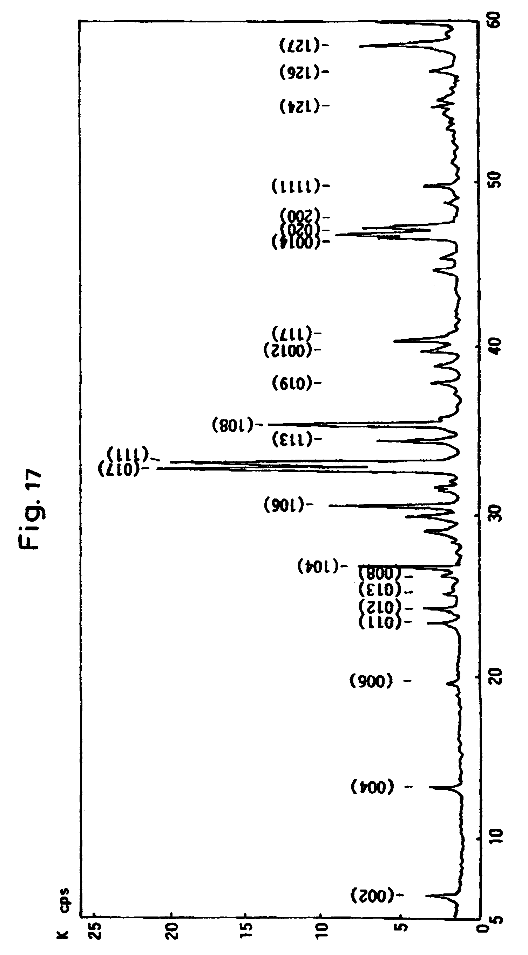

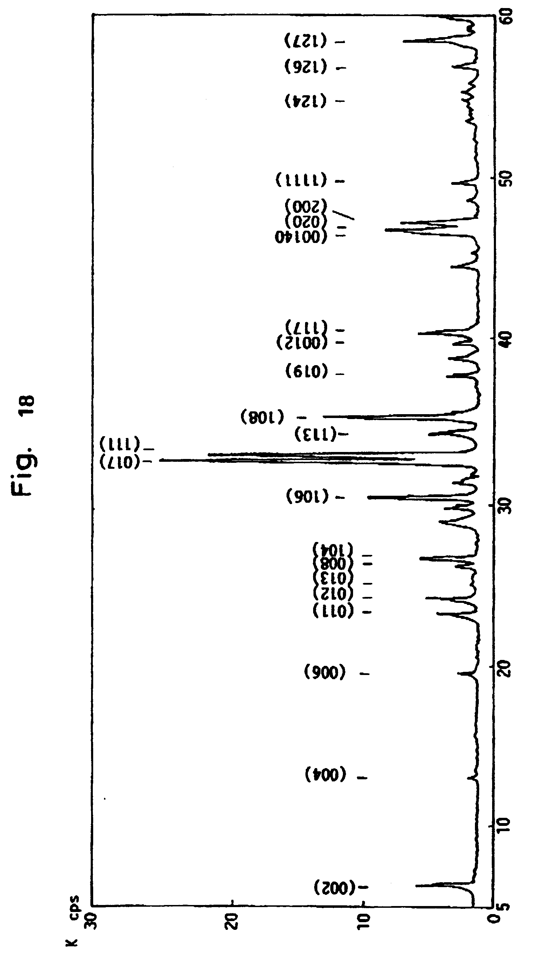

The resultant products were subjected to powder X-ray diffractiometry. A portion of the results is shown in Figs. 17 and 18. Fig. 17 corresponds to Y_{0.9}Ca_{0.1}Ba₂Cu₄O₈ and Fig. 18 corresponds to Ho_{0.95}Ca_{0.05}Ba₂Cu₄O₈. The powder X-ray pattern in Fig. 17 shows that the resultant powder phase shows the YBa₂Cu₄O₈ type structure, while the powder X-ray pattern in Fig. 18 shows that the resultant powder phase shows the YBa₂Cu₄O₈ type structure.

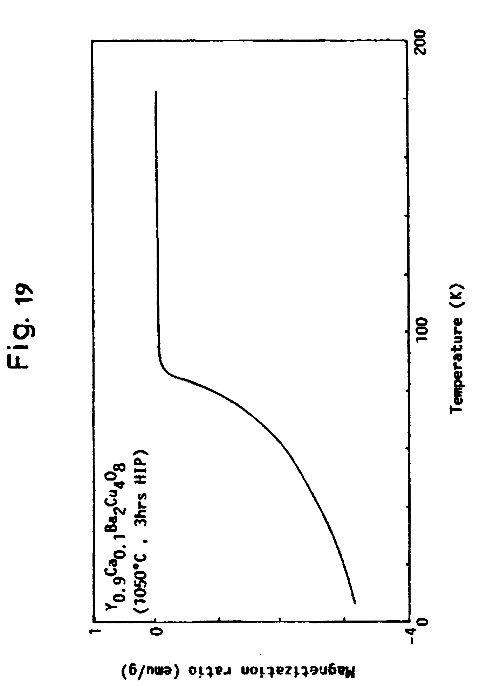

Further, superconducting characteristics of the powder specimens were measured by using vibrating sample magnetometer. A portion of the results is shown in Fig. 19. Fig. 19 corresponds to (Y_{0.9}Ca_{0.1})Ba₂Cu₄O₈.

(Y₁₋ₓCaₓ)Ba₂Cu₄O₈ (x = 0, 0.05, 0.1, 0.2) and (Ho₁₋ₓCaₓ)Ba₂Cu₄O₈ (x = 0, 0.05, 0.1, 0.2) were selected as samples not showing the 1-2-3 phase, in addition to the 1-2-4 phase as the result of the powder X-ray diffractiometry, and Meissner volume fraction at 4.2K and Tc value are shown in Table 7.

**Table 7**

| X | (Y₁₋ₓCaₓ)Ba₂Cu₄0₈ | (Ho₁₋ₓCaₓ)Ba₂Cu₄0₈ |
|---|---|---|
| 0 | 72% Tc = 81K | 45% Tc = 77K |
| 0.05 | 89% Tc = 84K | 30% Tc = 81K |
| 0.1 | 95% Tc = 90K | 50% Tc = 86K |
| 0.2 | 65% Tc = 90K | 30% Tc = 88K |

As apparent from comparison of Table 7 with Table 6, it can be seen that (R₁₋ₓCaₓ)Ba₂Cu₄O₈ type oxide super conductors can be obtained in a short period of time and at a high yield by controlling such that the 1-2-3 phase is not formed.

### Example 8

Each of powders of Y₂O₃, BaCO₃, CuO, CaCO₃ at 99.9% purity was mixed such that x is 0.1 in (Y₁₋ₓCaₓ) and applied with a calcination treatment in air at 880° C for 16 hrs. After pulverizing the calcined powder, it was applied with an HIP treatment in a mixed gas atmosphere of Ar-80%, O₂-20% under 100MPa (1000 atm) (partial oxygen pressure P_{O2} = 20MPa (200 atm)) at 980° C x 10 hrs.

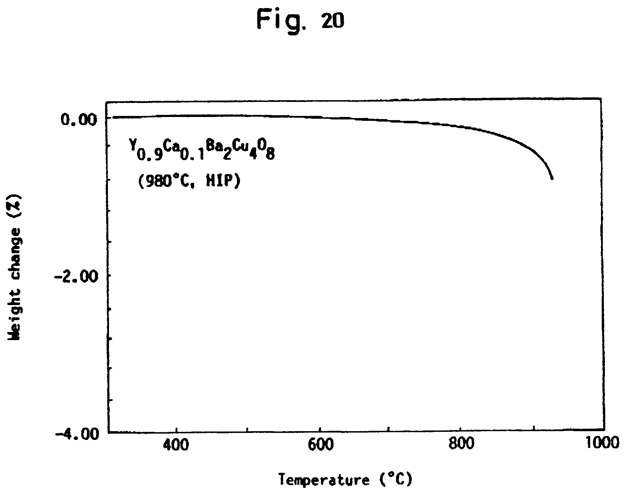

When the resultant powder was applied with thermogravimetric analysis, the results shown in Fig. 20 were obtained. As apparent from Fig. 20, it can be seen that the obtained powder is free from the release of oxygen and change of weight upto about 850°C.

The resultant superconducting powder was packed in a silver tube of 5 mm outer diameter, 3 mm inner diameter and 80 mm length one end of the tube was tightly sealed with a silver cap and, subsequently, the pipe was tightly sealed at one end thereof with a silver cap and closed at the other end thereof with a silver cap having a small aperture (0.1 mm⌀), evacuated to 1330Pa (10¹ Torr) so as not to scatter the powder and, finally, the tube was sealed by crushing the cap. After drawing it into a wire of 0.75 mm⌀ in outer diameter by swaging fabrication, it was applied with roll fabrication into a tape-shape of 0.2 mm thickness. Then, it was sintered by an HIP treatment in an Ar atmosphere, under a total pressure of 100MPa (1000 atm) and at a temperature of 830° C for 10 hrs. Separately, sintering in air at 830° C x 10 hrs was also applied.

When superconducting characteristics of the resultant oxide superconductor wire material were examined, the results shown in Table 8 were obtained. Jc in Table 8 is a critical current density under liquid nitrogen temperature (77K).

**Table 8**

| Sintering condition | Tc | Jc* (H=0) |
|---|---|---|
| Ar=HIP | 85K | 6820 A/cm² |
| Atmospheric pressure sintering | 86K | 3630 A/cm² |

| | | |
|---|---|---|
| * JC shows a mean value for 10 samples specified at 0.5 uV/cm. | | |

### Industrial Applicability

As has been described above according to the present invention, it can be realized an oxide superconductor having a superconducting transition temperature sufficiently higher than the liquid nitrogen temperature and causing no release of oxygen at a high temperature during fabrication, as well as a method capable of obtaining such an oxide superconductor in a short period of time and at a high yield. Further, the oxide superconductor according to the present invention can be used generally in the field such as wirings and magnetic shieldings for low temperature electronic apparatus.

## Claims

1. An oxide superconductor represented by the chemical formula (R₁₋ₓCaₓ)Ba₂Cu₄O₈, wherein R comprises one or more of elements selected from the group consisting of Y and lanthanide series rare earth elements and x is within a range: 0001 ≦ x ≦ 0.5.

2. An oxide superconductor as defined in claim 1, wherein R is Y and x is within a range: 0.001 ≦ x ≦ 0.2.

3. An oxide superconductor as defined in claim 1, wherein R is Y and x is within a range: 0.2 < x ≦ 0.5.

4. A method of manufacturing an oxide superconductor having a structure: (R₁₋ₓCaₓ)Ba₂Cu₄O₈ wherein R and x are defined as in claim 1, which comprises calcinating starting material powders, and then applying a hot isostatic pressing treatment in a mixed atmosphere of an inert gas and an oxygen gas.

5. A method of manufacturing an oxide superconductor in which an oxide superconductor containing an oxide represented by:
(R₁₋ₓCaₓ)Ba₂Cu₄O₈
(in which x is from 0.001 to 0.5 and R has the same meanings as described above) is formed by applying a hot isostatic pressing treatment to a starting powder mixture for manufacturing an oxide superconductor comprising R (in which R comprises one or more of elements selected from the group consisting of Y and lanthanide series rare earth elements), Ca, Ba, Cu and O in a mixed atmosphere of an inert gas and an oxygen, within a temperature range from 850 to 1100° C.

6. A manufacturing method as defined in claim 5, wherein R is Y and x is within a range: 0.001 ≦ x ≦ 0.2.

7. A manufacturing method as defined in claim 5 or 6, wherein an oxide superconductor containing an oxide represented by (R₁₋ₓCaₓ)Ba₂Cu₄O₈ is formed without forming an oxide as an intermediate product represented by (R₁₋ₓCaₓ)Ba₂Cu₃O₇ before the hot isostatic pressing treatment.

8. A method of manufacturing an oxide superconductor wire which comprises forming an oxide superconductor powder containing an oxide represented by
(R₁₋ₓCaₓ)Ba₂Cu₄O₈
(in which x is from 0.001 to 0.5 and R has the same meanings as described above), by applying a hot isostatic pressing treatment to a starting powder mixture for manufacturing an oxide superconductor comprising R (in which R comprises one or more of elements selected from the group consisting of Y and lanthanide series rare earth elements), Ca, Ba, Cu and O, in a mixed atmosphere of an inert gas and an oxygen gas within a temperature range from 850 to 1100° C, charging said powder into a sheath member, drawing the same into a wire and then applying sintering.

9. A manufacturing method as defined in claim 8, wherein an oxide superconductor powder containing an oxide represented by (R₁₋ₓCaₓ)Ba₂Cu₄O₈ is formed without forming an oxide as an intermediate product represented by (R₁₋ₓCaₓ)Ba₂Cu₃O₇ before hot isostatic pressing treatment

## Patentansprüche

1. Oxid-Supraleiter, dargestellt durch die chemische Formel (R₁₋ₓCaₓ)Ba₂Cu₄O₈, wobei R ein oder mehrere Elemente umfaßt, die aus der Gruppe ausgewählt sind, die aus Y und Seltenerdelementen der Lanthanreihe besteht, und x in einem Bereich 0,001 ≦ x ≦ 0,5 ist.

2. Oxid-Supraleiter nach Anspruch 1, wobei R Y ist und x in einem Bereich 0,001 ≦ x ≦ 0,2 ist.

3. Oxid-Supraleiter nach Anspruch 1, wobei R Y ist und x in einem Bereich 0,2 ≦ x ≦ 0,5 ist.

4. Verfahren zur Herstellung eines Oxid-Supraleiters mit der Struktur (R₁₋ₓCaₓ)Ba₂Cu₄O₈, wobei R und x wie in Anspruch 1 definiert sind, das das Calcinieren von Ausgangsmaterialpulvern und dann die Anwendung einer heißen isostatischen Druckbehandlung in einer vermischten Atmosphäre aus einem inerten Gas und einem Sauerstoffgas umfaßt.

5. Verfahren zur Herstellung eines Oxid-Supraleiters, bei dem ein Oxid-Supraleiter, der ein durch
(R₁₋ₓCaₓ)Ba₂Cu₄O₈
(wobei x von 0,001 bis 0,5 ist und R dieselbe Bedeutung wie vorstehend beschrieben hat) dargestelltes Oxid enthält, durch Anwenden einer heißen isostatischen Druckbehandlung auf eine Ausgangspulvermischung zur Herstellung eines OxidSupraleiters mit R (worin R ein oder mehrere Elemente umfaßt, die aus der Gruppe ausgewählt sind, die aus Y und Seltenerdelementen der Lanthanreihe besteht), Ca, Ba, Cu und O in einer vermischten Atmosphäre aus einem inerten Gas und Sauerstoff in einem Temperaturbereich von 850 bis 1100 °C gebildet wird.

6. Herstellungsverfahren nach Anspruch 5, wobei R Y ist und x in einem Bereich 0,001 ≦ x ≦ 0,2 liegt.

7. Herstellungsverfahren nach einem der Ansprüche 5 oder 6, wobei ein Oxid-Supraleiter, der ein durch (R₁₋ₓCaₓ)Ba₂Cu₄O₈ dargestelltes Oxid enthält, gebildet wird, ohne ein Oxid, das durch (R₁₋ₓCaₓ)Ba₂Cu₃O₇ dargestellt wird, als Zwischenprodukt vor der heißen isostatischen Druckbehandlung zu bilden.

8. Verfahren zur Herstellung eines Oxid-Supraleiterdrahts, das die Bildung eines Oxid-Supraleiterpulvers, das ein durch
(R₁₋ₓCaₓ)Ba₂Cu₄O₈
(worin x von 0,001 bis 0,5 ist und R dieselbe Bedeutung wie vorstehend beschrieben hat) dargestelltes Oxid enthält, durch Anwenden einer heißen isostatischen Druckbehandlung auf eine Ausgangspulvermischung zur Herstellung eines Oxid-Supraleiters mit R (wobei R ein oder mehrere Elemente umfaßt, die aus der Gruppe ausgewählt sind, die aus Y und Seltenerdelementen der Lanthanreihe besteht), Ca, Ba, Cu und O in einer vermischten Atmosphäre aus einem inerten Gas und einem Sauerstoffgas in einem Temperaturbereich von 850 bis 1100°C, Füllen des Pulvers in ein Umhüllungselement, Ziehen desselben zu einem Draht und dann Anwenden von Sintern umfaßt.

9. Herstellungsverfahren nach Anspruch 8, bei dem ein Oxid-Supraleiterpulver, das ein durch (R₁₋ₓCaₓ)Ba₂Cu₄O₈ dargestelltes Oxid enthält, gebildet wird, ohne ein Oxid, das durch (R₁₋ₓCaₓ)Ba₂Cu₃O₇ dargestellt wird, als Zwischenprodukt vor der heißen isostatischen Druckbehandlung zu bilden.

## Revendications

1. Oxyde supraconducteur représenté par la formule chimique (R₁₋ₓCaₓ)Ba₂Cu₄O₈, dans lequel R comprend un ou plusieurs des éléments choisis dans le groupe comprenant le Y et des éléments de terre rare de la série des lanthanides et x est tel que : 0,001 ≦ x ≦ 0,5.

2. Oxyde supraconducteur selon la revendication 1, dans lequel R est Y et x est tel que : 0,001 ≦ x ≦ 0,2.

3. Oxyde supraconducteur selon la revendication 1, dans lequel R est Y et x est tel que : 0,2 < x ≦ 0,5.

4. Procédé de fabrication d'un oxyde supraconducteur ayant une structure en (R₁₋ₓCaₓ)Ba₂Cu₄O₈, dans lequel R et x sont définis selon la revendication 1, procédé comprenant la calcination des poudres de matériau de départ puis l'application d'un traitement thermique sous pression isostatique dans une atmosphère de mélange d'un gaz inerte et d'un gaz d'oxygène.

5. Procédé de fabrication d'un oxyde supraconducteur dans lequel l'oxyde supraconducteur, contenant un oxyde représenté par (R₁₋ₓCaₓ)Ba₂Cu₄O₈ (dans lequel x est compris entre 0,001 et 0,5 et R possède la même signification que celle décrite ci-dessus), est formé par application d'un traitement thermique sous pression isostatique à un mélange de poudre de départ pour la fabrication d'un oxyde supraconducteur comprenant R (dans lequel R comprend un ou plusieurs des éléments choisis dans le groupe comprenant Y et des éléments de terre rare de la série des lanthanides), Ca, Ba, Cu et O, dans une atmosphère de mélange d'un gaz inerte et d'oxygène dans un intervalle de température de 850 à 1100°C.

6. Procédé de fabrication selon la revendication 5, selon lequel R est Y et x est tel que : 0,001 ≦ x ≦ 0,2.

7. Procédé de fabrication selon la revendication 5 ou 6, selon lequel un oxyde supraconducteur contenant un oxyde représenté par (R₁₋ₓCaₓ)Ba₂Cu₄O₈ est formé sans formation d'un oxyde en tant que produit intermédiaire représenté par (R₁₋ₓCaₓ)Ba₂Cu₃O₇ avant le traitement thermique sous pression isostatique.

8. Procédé de fabrication d'un fil d'oxyde supraconducteur comprenant la formation d'une poudre d'oxyde supraconducteur contenant un oxyde représenté par la formule (R₁₋ₓCaₓ)Ba₂Cu₄O₈ (dans laquelle x est compris entre 0,001 et 0,5 et R a la même signification que celle décrite ci-dessus), par application d'un traitement thermique sous pression isostatique à un mélange de poudre de départ pour la fabrication d'un oxyde supraconducteur comprenant R (dans lequel R comprend un ou plusieurs des éléments choisis dans le groupe constitué par Y et des éléments de terre rare de la série des lanthanides), Ca, Ba, Cu et O dans une atmosphère de mélange de gaz inerte et de gaz d'oxygène à une température comprise entre 850 et 1100°C, par chargement de ladite poudre dans une pièce de gainage, par étirage en un fil puis par application d'un frittage.

9. Procédé de fabrication selon la revendication 8, selon lequel une poudre d'oxyde supraconducteur contenant un oxyde représenté par (R₁₋ₓCaₓ)Ba₂Cu₄O₈ est formée sans formation d'un oxyde en tant que produit intermédiaire représenté par (R₁₋ₓCaₓ)Ba₂Cu₃O₇ avant le traitement thermique sous pression isostatique.
